(19) Europäisches Patentamt

European Patent Office

Office européen des brevets

(11) **EP 1 548 930 A1**

(12) **EUROPEAN PATENT APPLICATION**

(43) Date of publication:
**29.06.2005 Bulletin 2005/26**

(51) Int Cl.$^7$: **H03F 1/32**

(21) Application number: **03293319.4**

(22) Date of filing: **23.12.2003**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK**<br><br>(71) Applicant: **ALCATEL**<br>**75008 Paris (FR)**<br><br>(72) Inventors:<br>• **Jacob, Gunther**<br>  **71277 Rutesheim (DE)** | • **Schwörer, Gabriele**<br>  **71263 Weil der Stadt (DE)**<br>• **Schäpperle, Jörg**<br>  **70180 Stuttgart (DE)**<br><br>(74) Representative: **Schäfer, Wolfgang, Dipl.-Ing. et al**<br>  **Dreiss, Fuhlendorf, Steimle & Becker**<br>  **Postfach 10 37 62**<br>  **70032 Stuttgart (DE)** |

(54) **Electronic circuit and method for predistorting a signal to be amplified**

(57) The invention relates to an electronic circuit (100) and a method for processing an input signal, in particular in a wireless communication system. Known embodiments of said electronic circuit comprise a predistorter means (110) for generating a predistored signal (y) by predistorting said input signal (x) and a non-linear processing means (120) for generating a processed signal (z) which is substantially free from distortions by processing said received predistored signal (y). For updating coefficients (ai) of said predistorter known electronic circuits comprise an updating means (130). In order to reduce the complexity of said updating means (130) the updating means according to the invention is embodied to update said predistorter coefficients ($a_i$) in response to the input signal (x) and the processed signal (z).

*Fig. 2*

EP 1 548 930 A1

Printed by Jouve, 75001 PARIS (FR)

## Description

The invention relates to an electronic circuit and to a method, in particular of a wireless communications system for processing an input signal. Moreover, the invention relates to a computer program for carrying out said method, to a data storage means for storing said computer program, as well as to a radio transmitter, a base station, a radio terminal and a mobile radio system, each comprising the electronic circuit.

In the prior art, in particular from the article "A new Volterra predistorter based on the indirect learning architecture" from Eun Changsoo and Powers, Edward J. in IEEE transactions on signal processing, Vol. 45, No. 1, pp 223-227, January 1997, such electronic circuits and methods are in principle known. Said article substantially discloses an electronic circuit, in particular a power amplifier circuit, comprising two distorter units. An input signal is input into a first predistorter unit which outputs a predistorted signal to a non-linear processing means, in particular a power amplifying means. Said non-linear power amplifying means outputs an amplified signal. The transfer behavior of said first predistorter means substantially represents the inverse behavior of the non-linear distorting behavior of said non-linear power amplifying means. Consequently, the amplified signal output by said power amplifying means is substantially free from distortions. For achieving that coefficients of said first distorter means defining its transfer or distorting behavior are adapted regularly. In the mentioned prior art the adaptation of said coefficients is done by an updating means which outputs the updated coefficient to said distorter means. In the prior art said updating means is part of a feedback circuit in which the updated coefficient generated by said updating means are input to an auxiliary distorter means simulating or copying the inverse transfer behavior of said non-linear power amplifying means. The auxiliary distorter means gets a modified signal from the power amplifier output as a second input signal. The output of said auxiliary distorter is subtracted from a delayed version of said predistorted signal input to said power amplifying means and the result of said subtraction is fed back or input to said updating means.

Said described known closed loop for updating the coefficients of the predistorter comprising said auxiliary distorter means is provided in the prior art to ensure that the described difference signal representing the result of the described subtraction is a strictly linear function of said coefficients. This linearity complies with the requirements of adaptive algorithms like the least means square LMS algorithm running in said updating means.

However, due to the described closed loop including the auxiliary distorter means the structure known for such power amplifier circuits is rather complex.

Starting from that prior art it is the object of the invention to modify a known electronic circuit as well as a radio transmitter, a base station, a radio terminal and a mobile system each comprising said electronic circuit, a method for processing signals as well as a computer program for carrying out said method and a data storage means for storing such a computer program in such a way that the complexity of their architectures is reduced.

This object is solved by the subject-matter of claim 1. The electronic circuit claimed by claim 1 is characterized in that the updating means is embodied to update said predistorter coefficients in response to the input signal and the processed signal.

Advantageously, in comparison to the prior art an auxiliary distorter is dispensable and the claimed electronic circuit only comprises one distorter means, in particular a predistorter means being connected in series upstream with a non-linear processing means. The structure or hardware architecture of the claimed electronic circuit is less complex and may thus be manufactured a cheaper way.

Due to the lapse of the closed loop and the auxiliary distorter known from the prior art a difference signal input into an updating unit does not strictly represent a linear function of the coefficients of the predistorter means as strictly speaking required by the adaptive algorithm running on the updating means. However, for weakly non-linear processing means said difference signal does at least substantially represent a linear function of the coefficients and thus the desired configuration of said adaptive algorithm which depends on the linearity of the difference signal is not influenced significantly.

Advantageously, instead of the mentioned LMS algorithm, the updating unit may alternatively run more enhanced algorithms like the recursive least square RLS algorithm.

Stability in the provision of the coefficients and in the processing of the input signal is enhanced by clipping the updated coefficients or their correction addends such that they do not extend predefined threshold values.

Adaptive predistortion is advantageously improved if the predistorter runs a piecewise polynominal algorithm based on Hermite base functions as for example described in the not prepublished European patent application of Alcatel having the application No. 03 291281.8.

Further advantageous embodiments of the claimed electronic circuit are subject matters of the dependent claims.

The above-mentioned object of the invention is further solved by a radio transmitter, by a base station, by a radio terminal and by a mobile radio system each comprising the electronic circuit as described above. Moreover, the object of the invention is solved by a method for processing an input signal, a computer program for carrying out said method and by a data storage means for storing at least said computer program. The advantages of said solutions of the object substantially correspond to the advantages of the electronic circuit as described above.

There are four figures accompanying the description, wherein

Figure 1    shows a block diagram of the electronic circuit according to the invention;

Figure 2    shows a block diagram of an updating means according to the invention;

Figure 3    shows a more detailed diagram of the updating means in combination with a predistorter means; and

Figure 4    shows a detailed block diagram of a non-linear processing means.

In the figures a double arrow => represents complex signals whereas a single arrow -> represents real signals.

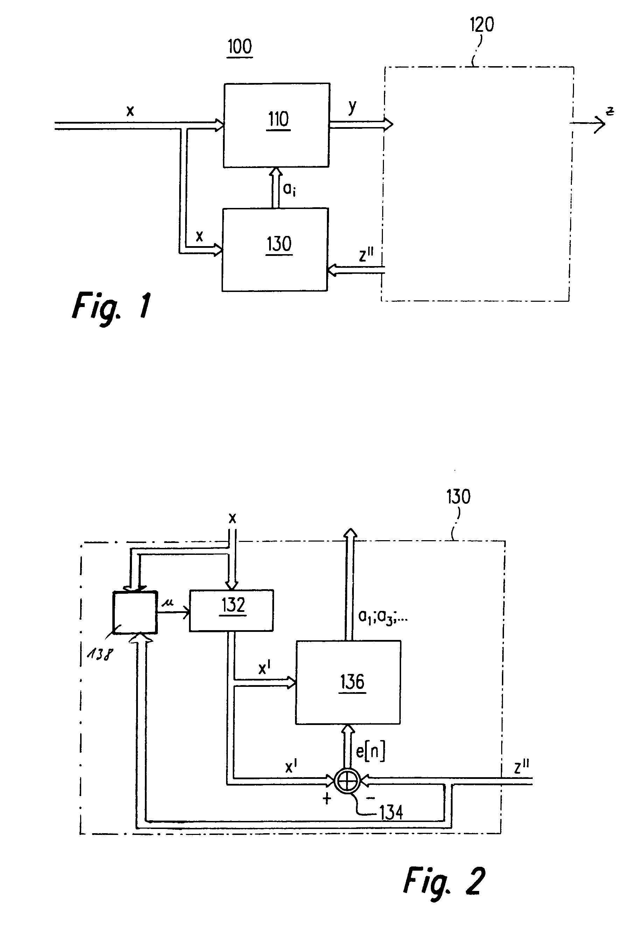

In the following embodiments of the invention will be described in detail by referring to the mentioned figures 1 to 4.

Figure 1 shows the electronic circuit 100 according to the invention. Said circuit is preferably used in a wireless communications system. It serves for processing an input signal x into a processed signal z. For generating said processed signal z the electronic circuit 100 comprises a non-linear processing means 120. Said processing means 120 may for example be embodied as a power amplifying means for amplifying the input signal or as an electro-optical converting means for converting the electronic input signal into an optical output signal.

Disadvantageously, said processing means 120 does not only process, e.g. amplify or convert a signal, but also generates distortions on it due to its non-linear transfer behavior. In order to nevertheless generate the processed signal z at the output of said non-linear processing means 120 substantially free from said distortions, the electronic circuit 100 comprises a predistorter means 110 which is switched in series in front or upstream of said non-linear processing means 120. Preferably, the transfer behavior of said predistorter means 110 is designed such that it represents the inverse transfer behavior of said non-linear processing means 120. The predistorter means then generates a predistorted signal y comprising distortions which represent the inverse of the distortions which will be added to that signal later on when it is processed by the non-linear processing means 120. The inverse distortions of the predistorted signal y and the distortions added to said signal by the non-linear power processing means 120 cancel out for each other with the result that the processed signal z at the output of the non-linear processing means is substantially free from distortions.

However, this is only achieved if the coefficients of said predistorter means are updated appropriately regularly. The updating of said predistorter coefficients $a_i$ is done in an updating means 130 of said electronic circuit 100.

In the following it is -by example- assumed that the processing means 120 is embodied as power amplifying means; consequently, the processed signal z is hereinafter referred to as amplified signal z.

Figure 2 shows a detailed block diagram of said updating means 130. It comprises a delay unit 132 for delaying the input signal x of the electronic circuit 100. The fist delay unit 132 compensates for the time delay in the non-linear power amplifying means 120. A resulting delayed signal x' output by said delay unit 132 is input into a subtracting unit 134 as well as into an updating unit 136. The subtracting unit 134 generates a difference signal e by subtracting a modified amplified signal z" from said delayed input signal x'.

In the case that the required time delay is time-variant, the updating means 130 advantageously further comprises a second updating unit 138 for updating the time delay. The second updating means 138 receives the signals x and z" as input signals and calculates a control signal u representing the updated time delay between said two input signals x and z" wherein the control signal u is input into the delay unit 132, preferably in the form of appropriate filter coefficients.

A possible realization for the first and the second delay unit 132 and 138 is to use an adaptive finite-impulse-response FIR filter as the delay unit 132 and another LMS algorithm as updating means 138.

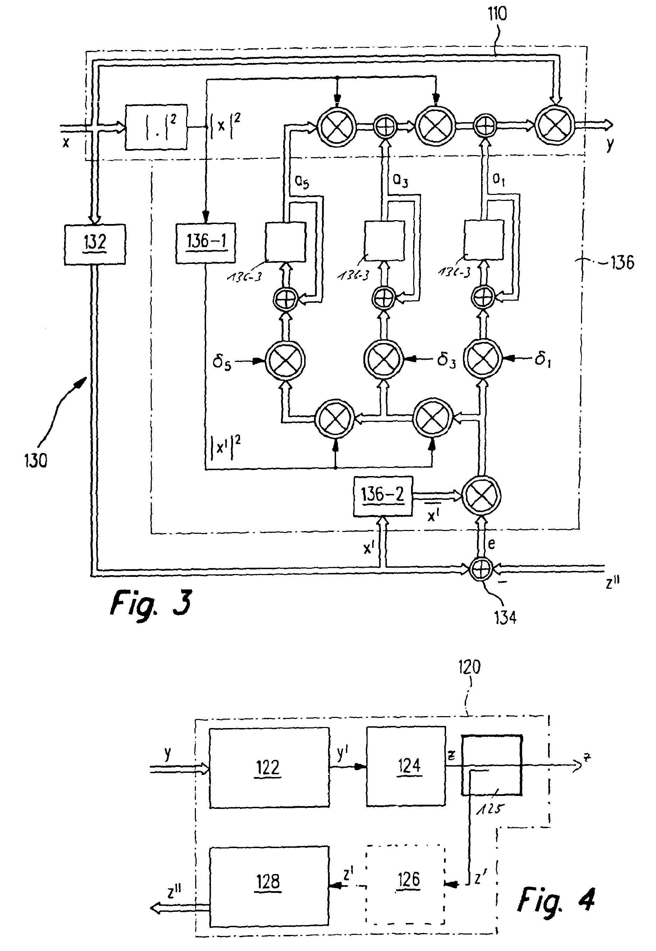

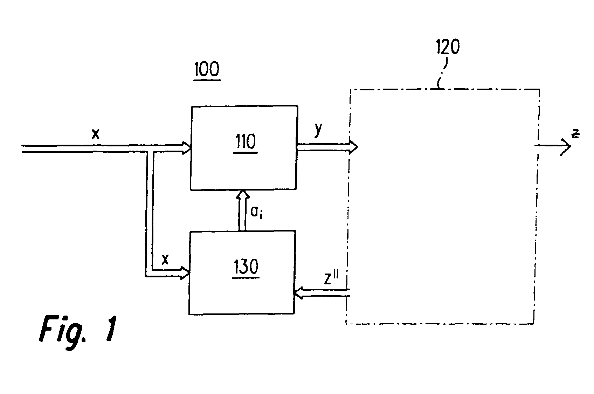

The generation of said modified amplified signal z" is described below by referring to Figure 4; however, the signal z" substantially represents the amplified signal z as output by the non-linear power amplifying means 120.

The updating unit 136 generates said required updated coefficients $a_i$ for the predistorter means 110 in response to said delayed input signal x' and said difference signal e. The updating unit 136 generates the coefficients $a_i$ by running a least means square LMS algorithm or any other suitable algorithm like e. g. the recursive least square RLS algorithm. If the updating unit 136 runs the LMS algorithms the update operation can be described by the following equations:

$$a_1[n + 1] = a_1[n] + \delta_1 \bar{x}^i e \qquad (1)$$

$$a_3[n + 1] = a_3[n] + \delta_3|x'|^2 \bar{x}^i \, e \tag{2}$$

$$a_5[n + 1] = a_5[n] + \delta_5|x'|^4 \bar{x}^i \, e \tag{3}$$

$$... \tag{4}$$

where $\delta_1$, $\delta_3$, $\delta_5$, ... are real valued step width parameters and x' is the conjugate complex of a variable x'.

An example for a possible implementation of these equations is shown in Figure 3. Block 136-1 represents a delay unit for delaying the variable $|x^2|$. Block 136-2 represents a unit for generating the conjugate complex of the complex delayed input signal x'. In Figure 3 the conjugate complex of the delayed input signal x' is represented by the variable $\bar{x}'$.

The delay units 136-3 delay their input signals by one sample clock-time. The remaining symbols in Figure 3 representing multipliers and adders are self-evident and need no further explanation. However, it should be mentioned that the other delay unit 136-1 may be replaced by another block (not shown) within said updating unit 136 which is able to generate the required variable $|x'|^2$ from the delayed input signal x'.

Figure 3 does not only show an embodiment for the updating unit 136 but also an example for implementing the whole updating means 130 in conjunction with the predistorter means 110 known from Figure 1. More specifically, the predistorter 110 shown in Figure 3 shows an example of a polynominal approach for establishing an appropriate transfer behavior of said predistorter means 110. The polynominal approach implemented in block 110 of Figure 3 can mathematically be described by the following input-output relation (5):

$$y[n] = \sum_{i=0}^{N} a_{2i+1}\Big| \, x[n] \, \Big|^{2i} x[n] \tag{5}$$

It can be taken from Figure 3 that the predistorter means 110 generates the predistorted signal y by transforming the input signal x according to relation (5) wherein the required coefficients $a_i$ with i = 1, 3, 5, ... are online provided by said updating unit 136. Even indexes are dropped out.

Finally, the non-linear power amplifying means 120 shall be discussed in more detail by referring to Figure 4.

Figure 4 shows that the predistored signal y which represents a baseband signal is input into a first converting unit 122 for being converted into a radio frequency RF-signal y'. After said conversion the RF-signal is input into a non-linear power amplifying unit 124 which generates the amplified signal z by amplifying (and distorting) said RF-signal y'. Said amplified signal z is output for being further processed.

However, said amplified signal z is further input into a power splitter 125 that separates an attenuated version z' from the signal z. Optionally, said attenuated signal z' is further attenuated by an optionally additionally provided attenuator unit 126 for reversing the amplification done by said power splitter and/or by said non-linear power amplifying unit 124. However, said attenuation is done without removing the distortions in the amplified signal z caused by the amplification of said non-linear power amplifying unit 124. Further, the attenuated signal z' representing a RF-signal is down-converted by a second converting unit 128 into the above-mentioned modified amplified signal z" representing a baseband BB signal.

The first converting unit 122 comprises the steps of quadrature modulation, digital to analog conversion and frequency up-conversion in an arbitrary sequence. Similarly, the second converting unit 128 comprises the steps of frequency down-conversion, analog to digital conversion and quadrature demodulation in an arbitrary sequence.

The electronic circuit 100 according to the invention may be implemented within a radio transmitter, a base station, a radio terminal or a mobile radio system in particular of a wireless communications system.

The method according to the invention may be established in a Field Programable Gate Array FPGA or in the form of a computer program. Such a computer program might be stored on a data storage means. The data storage means may be a compact disc or a so-called flash memory etc. The computer program may be transferred or purchased to a customer when being stored on said data storage means. However, the computer program may alternatively be transferred to the customer via an electronic communications network, in particular the internet.

**Claims**

1. Electronic circuit (100), in particular of a wireless communications system, for amplifying an input signal (x), comprising:

   a predistorter means (110) for generating a predistorted signal (y) by predistorting the input signal (x) pursuant to the transfer behavior of the predistorter means (110) defined by predistorter-coefficients ($a_i$);

   a non-linear processing means (120), in particular a power amplifying means, for generating a processed signal (z) by processing, in particular by amplifying said received predistorted signal (y); and

   an updating means (130) for updating said predistorter-coefficients ($a_i$) and outputting the updated coefficients ($a_i$) to said predistorter means (110) ;

   **characterized in that**
   the updating means (130) is embodied to update said predistorter coefficients ($a_i$) in response to the input signal (x) and the processed signal (z).

2. Electronic circuit (100) according to claim 1, **characterized in that** the updating means (130) comprises:

   a delay unit (132) for generating a delayed input signal (x') by delaying the input signal (x);

   a subtracting unit (134) for generating a difference signal (e) by subtracting the amplified signal (z) - preferably after attenuation and down-conversion in the form of a baseband signal (z") - from said delayed input signal (x'); and

   a first updating unit (136) for updating the predestorter-coefficients ($a_i$) in response to said delayed input signal (x') and said difference signal (e).

3. Electronic circuit (100) according to claim 2, **characterized in that** said first updating unit (136) is embodied to run a least mean square LMS or a recursive least square RLS algorithm.

4. Electronic circuit (100) according to claim 3, **characterized in that** the first updating unit (136) is embodied to recursively calculate an updated coefficient ($a_i$) by adding a correction addend to a previously calculated coefficient, wherein the correction addend or the updated coefficient preferably do not extend predefined threshold values.

5. Electronic circuit (100) according to one of claims 2, 3, 4, **characterized in that** the difference signal (e) is represented by an at least substantially linear function of previously updated predistorter-coefficients ($a_i$).

6. Electronic circuit (100) according to one of claims 2 to 5, **characterized in that** the updating means (130) further comprises a second updating unit (138) for updating a time delay in the non-linear processing means (120) in response to the received signals x and z" and for providing a control signal representing said time delay to the delay unit 132.

7. Electronic circuit (100) according to one of the preceding claims, **characterized in that** the transmission behavior of said predistorter means (110) is represented by a mathematical polynominal approach.

8. Electronic circuit (100) according to claim 7, **characterized in that** the polynominal approach only comprises odd polynominal coefficients ($a_i$).

9. Electronic circuit (100) according to one of the preceding claims 1 - 6, **characterized in that** the transmission behavior of said predistorter means (110) is represented by a piecewise polynominal algorithm based on Hermite base functions.

10. Electronic circuit (100) according to one of the preceding claims 1 - 6, **characterized in that** the transmission behavior of said predistorter means (110) is represented by a look-up table.

11. Electronic circuit according to one of the preceding claims, **characterized in that** the non-linear processing means (120) comprises:

a first converting unit (122) for converting the predistored signal (y) representing a baseband (BB) signal into a radio frequency RF signal (y');

a non-linear processing unit (124), advantageously a power amplifying unit, for generating the processed signal (z) by processing, advantageously amplifying said RF-signal (y');

a power splitter unit (125) for separating an attenuated signal (z') from the processed signal (z); and

a second converting unit (128) for down converting said attenuated RF-signal (z') into a baseband signal (z'').

12. Electronic circuit according to claim 11, **characterized in that** the processing means (120) further comprises an attenuator unit (126) for further attenuating the attenuated signal (z') without removing distortions in it caused by said non-linear power amplifying unit (124) before it is input into said second converting unit (128).

13. Radio transmitter, in particular of a wireless communication system, for transmitting radio signals comprising an electronic circuit (100) having:

a predistorter means (110) for generating a predistorted signal (y) by predistorting the input signal (x) pursuant to the transfer behavior of the predistorter means (110) defined by predistorter-coefficients ($a_i$);

a non-linear processing means (120), preferably an amplifying means, for generating a processed signal (z) by processing said received predistorted signal (y); and

an updating means (130) for updating said predistorter-coefficients ($a_i$) and outputting the updated coefficients ($a_i$) to said predistorter means (110);

**characterized in that**
the updating means (130) is embodied to update said predistorter coefficients ($a_i$) in response to the input signal (x) and the processed signal (z).

14. Base station, in particular of a wireless communication system, comprising an electronic circuit (100) having

a predistorter means (110) for generating a predistorted signal (y) by predistorting the input signal (x) pursuant to the transfer behavior of the predistorter means (110) defined by predistorter-coefficients ($a_i$);

a non-linear processing means (120), preferably an amplifying means, for generating a processed signal (z) by processing said received predistorted signal (y); and

an updating means (130) for updating said predistorter-coefficients ($a_i$) and outputting the updated coefficients ($a_i$) to said predistorter means (110);
**characterized in that**
the updating means (130) is embodied to update said predistorter coefficients ($a_i$) in response to the input signal (x) and the processed signal (z).

15. Radio terminal comprising an electronic circuit (100) having

a predistorter means (110) for generating a predistorted signal (y) by predistorting the input signal (x) pursuant to the transfer behavior of the predistorter means (110) defined by predistorter-coefficients ($a_i$);

a non-linear processing means (120), preferably an amplifying means, for generating a processed signal (z) by processing said received predistorted signal (y); and

an updating means (130) for updating said predistorter-coefficients ($a_i$) and outputting the updated coefficients ($a_i$) to said predistorter means (110);

**characterized in that**

the updating means (130) is embodied to update said predistorter coefficients ($a_i$) in response to the input signal (x) and the processed signal (z).

16. Mobile radio system comprising at least one radio terminal and a base station preferably each of which comprising an electronic circuit (100) having:

    a predistorter means (110) for generating a predistorted signal (y) by predistorting the input signal (x) pursuant to the transfer behavior of the predistorter means (110) defined by predistorter-coefficients ($a_i$);

    a non-linear processing means (120), preferably an amplifying means, for generating a processed signal (z) by processing said received predistorted signal (y) ; and

    an updating means (130) for updating said predistorter-coefficients ($a_i$) and outputting the updated coefficients ($a_i$) to said predistorter means (110);

    **characterized in that**
the updating means (130) is embodied to update said predistorter coefficients ($a_i$) in response to the input signal (x) and the processed signal (z).

17. Method for amplifying an input signal (x), in particular in a wireless communication system, comprising the steps of:

    predistorting the input signal (x) into a predistored signal (y) according to the transfer behavior of a predistorter means (110) which is defined by predistorter coefficients ($a_i$);

    processing said predistored signal (y) into a processed signal (z); and

    updating said predistorter coefficients ($a_i$);

    **characterized in that**
the updating of the predistorter coefficients ($a_i$) is carried out in response to said input signal and said processed signal (z).

18. Method according to claim 17, **characterized in that** the updating of the predistorter coefficients comprises the following steps:

    delaying the input signals (x);

    generating a difference signal (e) by subtracting the amplified signal (z) preferably after attenuation and down-conversion from said delayed input signal (x'); and

    updating the predistorter coefficients ($a_i$) in response to said delayed input signal (x') and said difference signal (e).

19. Computer program comprising code for an electronic circuit (100), a radio transmitter, a base station, a radio terminal or a mobile radio system; **characterized in that** said code is embodied to carry out the method according to one of claims 17 or 18.

20. Data storage means, **characterized in that** it stores at least the computer program according to claim 19.

**Fig. 1**

**Fig. 2**

**Fig. 3**

**Fig. 4**

Fig. 1

**European Patent Office**

## EUROPEAN SEARCH REPORT

Application Number

EP 03 29 3319

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 01/08294 A (DATUM TELEGRAPHIC INC) 1 February 2001 (2001-02-01) * page 9, line 16 - page 64, line 3; figures 18,35,37 * | 1,7-17, 19,20 | H03F1/32 |
| X | WO 02/101919 A (FUJITSU LTD ;HAMADA HAJIME (JP); KUBO TOKURO (JP); ODE TAKAYOSHI ()) 19 December 2002 (2002-12-19) | 1-5,7, 9-20 | |
| Y | * page 1, line 5 - page 17, line 9; figure 1 * | 6 | |
| X | US 2001/005402 A1 (KUBO TOKURO  ET AL) 28 June 2001 (2001-06-28) | 1,7, 9-17,19, 20 | |
| Y | * paragraph [0001] - paragraph [0061]; figure 1 * | 6 | |
| X | PATENT ABSTRACTS OF JAPAN vol. 2002, no. 02, 2 April 2002 (2002-04-02) & JP 2001 284976 A (MATSUSHITA ELECTRIC IND CO LTD), 12 October 2001 (2001-10-12) * abstract * | 1,7, 9-17,19, 20 | |
| X | US 2001/007435 A1 (HAMADA HAJIME  ET AL) 12 July 2001 (2001-07-12) * paragraph [0001] - paragraph [0119]; figures 1,3 * | 1,7, 9-17,19, 20 | TECHNICAL FIELDS SEARCHED (Int.Cl.7) H03F |
| X | US 2003/156658 A1 (DARTOIS LUC) 21 August 2003 (2003-08-21) * paragraph [0001] - paragraph [0093]; figures 2,3 * | 1,7, 9-17,19, 20 | |

The present search report has been drawn up for all claims

| Place of search | Date of completion of the search | Examiner |
|---|---|---|
| MUNICH | 13 May 2004 | Dietsche, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 03 29 3319

This annex lists the patent family members relating to the patent documents cited in  the above-mentioned European search report.
The members are as contained in the European Patent Office EDP file on
The European Patent Office is in no way liable for these particulars which are merely  given for the purpose of information.

13-05-2004

| Patent document cited in search report | | | Publication date | Patent family member(s) | | Publication date |
|---|---|---|---|---|---|---|
| WO 0108294 | A | | 01-02-2001 | US 6697436 B1 | | 24-02-2004 |
| | | | | AU 5840500 A | | 13-02-2001 |
| | | | | AU 5840800 A | | 13-02-2001 |
| | | | | AU 6009300 A | | 13-02-2001 |
| | | | | AU 6009400 A | | 30-01-2001 |
| | | | | AU 6309300 A | | 13-02-2001 |
| | | | | EP 1205024 A1 | | 15-05-2002 |
| | | | | EP 1203444 A1 | | 08-05-2002 |
| | | | | EP 1196986 A2 | | 17-04-2002 |
| | | | | EP 1203445 A1 | | 08-05-2002 |
| | | | | EP 1196988 A1 | | 17-04-2002 |
| | | | | EP 1280273 A2 | | 29-01-2003 |
| | | | | WO 0108294 A1 | | 01-02-2001 |
| | | | | WO 0108295 A1 | | 01-02-2001 |
| | | | | WO 0108296 A1 | | 01-02-2001 |
| | | | | WO 0105026 A1 | | 18-01-2001 |
| | | | | WO 0108297 A1 | | 01-02-2001 |
| | | | | US 6587514 B1 | | 01-07-2003 |
| | | | | US 6356146 B1 | | 12-03-2002 |
| | | | | US 6342810 B1 | | 29-01-2002 |
| | | | | US 2002008578 A1 | | 24-01-2002 |
| | | | | US 2002044014 A1 | | 18-04-2002 |
| | | | | US 2001050592 A1 | | 13-12-2001 |
| WO 02101919 | A | | 19-12-2002 | WO 02101919 A1 | | 19-12-2002 |
| US 2001005402 | A1 | | 28-06-2001 | JP 2001189685 A | | 10-07-2001 |
| JP 2001284976 | A | | 12-10-2001 | NONE | | |
| US 2001007435 | A1 | | 12-07-2001 | JP 2001251148 A | | 14-09-2001 |
| US 2003156658 | A1 | | 21-08-2003 | FR 2835120 A1 | | 25-07-2003 |
| | | | | CN 1434566 A | | 06-08-2003 |
| | | | | EP 1331729 A1 | | 30-07-2003 |
| | | | | JP 2003243940 A | | 29-08-2003 |

EPO FORM P0459

For more details about this annex : see Official Journal of the European Patent Office, No. 12/82